# EUROPÄISCHE PATENTSCHRIFT

(11) **EP 1 454 362 B1**
(45) Veröffentlichungstag und Bekanntmachung des Hinweises auf die Patenterteilung: **31.03.2010**
(21) Anmeldenummer: 02805263.7
(22) Anmeldetag: 09.12.2002
(51) Int. Cl.: H01L 51/10

(54) **ORGANISCHER FELD-EFFEKT-TRANSISTOR MIT VERSCHOBENER SCHWELLWERTSPANNUNG UND VERWENDUNG DAZU**
ORGANIC FIELD EFFECT TRANSISTOR WITH OFF-SET THRESHOLD VOLTAGE AND THE USE THEREOF
TRANSISTOR ORGANIQUE A EFFET DE CHAMP A TENSION DE SEUIL DEPHASEE ET SON UTILISATION

(30) Priorität: 11.12.2001 DE 10160732
(43) Veröffentlichungstag der Anmeldung: 08.09.2004
(73) Patentinhaber: PolyIC GmbH & Co. KG, 90763 Fürth (DE)
(72) Erfinder: ULLMANN, Andreas, 90513 Zirndorf (DE); FIX, Walter, DE-90427 Nürnberg (DE)
(74) Vertreter: LOUIS, PÖHLAU, LOHRENTZ
(86) Internationale Anmeldenummer: PCT/DE2002/004520
(87) Internationale Veröffentlichungsnummer: WO 2003/054970

(56) Entgegenhaltungen:
- EP-A- 0 528 662
- EP-A2- 0 786 820
- WO-A-02/065557
- WO-A2-2004/114371
- HOROWITZ G ET AL: "The concept of threshold voltage' in organic field-effect transistors" ADVANCED MATERIALS, 20 AUG. 1998, VCH VERLAGSGESELLSCHAFT, GERMANY, Bd. 10, Nr. 12, Seiten 923-927, XP002240947 ISSN: 0935-9648
- GUNDLACH D J ET AL: "High-mobility, low voltage organic thin film transistors" INTERNATIONAL ELECTRON DEVICES MEETING 1999. TECHNICAL DIGEST (CAT. NO.99CH36318), INTERNATIONAL ELECTRON DEVICES MEETING 1999. TECHNICAL DIGEST, WASHINGTON, DC, USA, 5-8 DEC. 1999, Seiten 111-114, XP002240948 1999, Piscataway, NJ, USA, IEEE, USA ISBN: 0-7803-5410-9
- GUNDLACH D. ET AL.: "Improved organic thin film transistor performance using chemically-modified gate dielectrics" PROCEEDINGS OF THE SPIE, Bd. 4466, 26. Juli 2001 (2001-07-26), Seiten 54-64,
- JACKSON T.N. ET AL.: "Organic thin film transistors for organic light-emitting flat-panel display backplanes" IEEE JOURNAL OF SELECTED TOPICS IN QUANTUM ELECTRONICS, Bd. 4, Nr. 1, Januar 1998 (1998-01), - Februar 1998 (1998-02) Seiten 100-104,
- MORITA S; ZAKHIDOV A A; YOSHINO K: "Doping effect of Buckminsterfullerene in conducting polymer: change of absorption spectrum and quenching of luminescence" SOLID STATE COMMUNICATIONS, Bd. 82, Nr. 4, April 1992 (1992-04), Seiten 249-252,
- DODABALAPUR A. ET AL.: "Organic field-effect bipolar transistors" APPLIED PHYSICS LETTERS, Bd. 68, Nr. 8, 19. Februar 1996 (1996-02-19), Seiten 1108-1110,
- DODABALAPUR A; ET AL: "ORGANIC HETEROSTRUCTURE FIELD-EFFECT TRANSISTORS" SCIENCE, Bd. 269, 15. September 1995 (1995-09-15), Seiten 1560-1562, XP000644688

## Beschreibung

Ein Schlüsselparameter bei organischen Feldeffekt-Transistoren (OFETs) ist die Lage der Schwellwertspannung. Diese Spannung gibt an, bei welcher Gate-Spannung der Stromkanal des Transistors entsteht oder leitfähig wird. Liegt diese nahe bei 0V, so treten beim Aufbau von integrierten Schaltungen aus diesen OFETs zwei Problemen auf: es werden zwei statt nur einer Spannungsversorgung benötigt und man braucht etwa die doppelte Anzahl von Transistoren, da die Ausgangsspannungen der Logikelemente verschoben werden müssen, bevor damit weitere Logikelemente angesteuert werden können. Folge dieser Probleme ist u.a. ein stark erhöhter Leistungsverbrauch, der gerade bei Anwendungen wie RF-ID-Tags (Radio-Frequency-Identification) einen Einsatz von Polymerelektronik, also Elektronik auf Basis organischer Materialien erschwert.

Bei den für zukünftige Anwendungen aussichtsreichsten OFETs, den auf Polyalkylthiophen basierenden, wie sie z.B. aus der Veröffentlichung von H. Sirringhaus (H. Sirringhaus, N. Tessler, et al. (1999). Elsevier Synthetic Metals 102: 857-860) bekannt sind, liegt die Schwellwertspannung nahe bei 0V. Bei OFETs mit Pentacene als Halbeleiter liegt die Schwellwertspannung sogar bei positiven Spannungen (C.D. Sheraw, J.A. Nichols et al. (2000), IEDM 2000, p.619-22). Es treten daher die oben beschriebenen Probleme auf. Da OFETs auf dem Prinzip der Ladungsträgerakkumulation basieren, lässt sich die Lage der Schwellwertspannung nicht, wie z.B. bei Si-MOS-FETs (Silizium-Metall-Oxid Feldeffekt-Transistoren) üblich, durch die Kanaldicke einstellen. Auch eine dickere Isolatorschicht verschiebt die Schwellwertspannung nur unwesentlich. Dadurch würde gleichzeitig das on/off-Verhältnis des OFETs deutlich verschlechtert. Die naheliegende Möglichkeit zur Verschiebung der Schwellwertspannung, nämlich eine Gate-Elektrode zu verwenden, welche eine niedrigere Austrittsarbeit hat, ist keine brauchbare Lösung, da sich solche aus leitfähigem organischen Material praktisch nicht realisieren lassen.

Aus der SPIE Vol 4466 (2001), Artikel "Improved Organic Thin Film Transistor Performance Using Chemically-Modified Gate Dielectrics" Gundlach D.J. et al, Seite 54 bis 64, 29.07.2001 ist weiter ein OFET bekannt, der wie folgt gefertigt wird: Aus eine Gate-Elektrode wird eine Silizium-Substratschicht aufgebracht auf der eine Thermisch gewachsene SiO₂-Schicht aufgebracht wird. Vor Abscheiden der organischen Halbleiterschicht wird die Oberfläche der SiO₂-Schicht durch aus der Gasphase abgeschiedene Octadecyltrichlorosilan (OTS)-Monoschichten Vorbehandelt. Anschließend wird die organische Halbleiterschicht auf die vorbehandelte Oberfläche aufgedampft.

Aufgabe der Erfindung ist es daher, eine Möglichkeit zur Verschiebung der Schwellwertspannung bei OFETs, insbesondere bei solchen, deren Schwellwertspannung nahe 0V oder im positiven Bereich liegt, zur Verfügung zu stellen. Außerdem ist es Aufgabe der Erfindung, Verwendungen von OFETs mit verschobener Schwellwertspannung zu offenbaren.

Gegenstand der Erfindung ist ein OFET nach Anspruch 1.

Als wird ein Bereich bezeichnet, in dem sich keine freien Ladungsträger befinden.

Die Zwischenschicht erzeugt eine Raumladungszone, die die Ausbildung eines leitfähigen Stromkanals bei kleinen Gate-Spannungen verhindert. Erst für größere Gate-Spannungen findet die normale Erzeugung eines Stromkanals statt. Damit wird die Schwellwertspannung verschoben, ohne dass die Nachteile wie Verringerung des ON/OFF-Verhältnisses etc. oder niedrigere Ausgangsströme in Kauf genommen werden müssen. Ob die Verschiebung der Schwellwertspannung 2V, 5V oder über 10V beträgt, hängt von der Dicke und der Donatorkonzentration der Zwischenschicht ab und kann durch geeignete Wahl je nach Bedarf eingestellt werden. Dies stellt einen wichtigen Vorteil der Erfindungsmeldung dar.

Ein weiterer Vorteil der Erfindung ist, dass OFETs mit dieser Zwischenschicht deutlich unempfindlicher gegenüber einer unabsichtlichen Hintergrunddotierung des Halbleiters sind, da diese aktiv durch die Zwischenschicht kompensiert wird. Das erleichtert die Herstellung von OFETs, da dann z.B. auf eine Herstellung unter Sauerstoffausschluss verzichtet werden kann.

Nach einer Ausführungsform ist die Zwischenschicht aus kleinen, polarisierbaren Molekülen mit internen Dipolmoment (z.B. Di-Sulfid-Dipolmoleküle) oder aus Silanen, Fullerenen oder Perylenen.

Nach einer Ausführungsform ist die Zwischenschicht einige wenige bis einige 10 Nanometer dick.

Bei der Herstellung organischer Transistoren oder organischer integrierter Schaltungen wird die Zwischenschicht auf die Halbleiterschicht (Top-Gate OFETs) aufgebracht. Dieses Aufbringen kann durch Aufschleudern, Aufgießen, Drucken, Bedampfen, Eintauchen in eine Lösung oder durch eine andere Aufbringungsmethode geschehen.

Die nachfolgende Erläuterung erfolgt anhand von Figuren die Ausführungsbeispiele der Erfindung mit p-leitende OFETs zeigen
Figuren 1a bis 1c zeigen den Stand der Technik zum Vergleich;
Figuren 2a bis 2c zeigen dieselben Ansichten bei einem Ausführungsbeispiel der Erfindung.

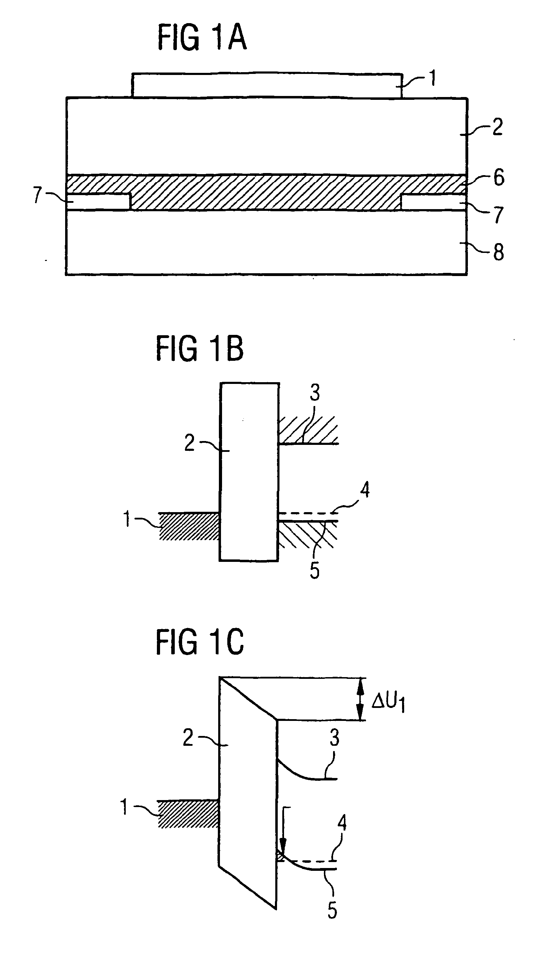

Figur 1a zeigt einen Querschnitt durch einen herkömmlichen OFET mit einem Substrat 8 (z.B. einer Plastikfolie), den strukturierten Source/Drain-Elektroden 7, der organischen Halbleiterschicht 6, der Isolatorschicht 2 und der Gate-Elektrode 1. Figur 1b zeigt die dazugehörige Lage der LUMO- bzw. HOMO- Energien für die Schichtabfolge Gate-Elektrode /Isolator / Halbleiter: LUMO-Energie 3 (entspricht der energetischen Lage des Leitungsbandes), HOMO-Energie 5 (entspricht der energetischen Lage des Valenzbandes) und das Fermi-Niveau 4. Eine Erhöhung der Gate-Spannung um ΔU₁ führt zu einer Akkumulation der Ladungsträger an der Grenzfläche zwischen Isolator und Halbleiter (9 in Figur 1c). Dies führt zu einer Anhebung der Energieniveaus in der organischen Halbleiterschicht 6 nahe der Grenzfläche. Die Erhöhung der Gate-Spannung führt also direkt zur Ausbildung eines Stromkanals 9 im OFET.

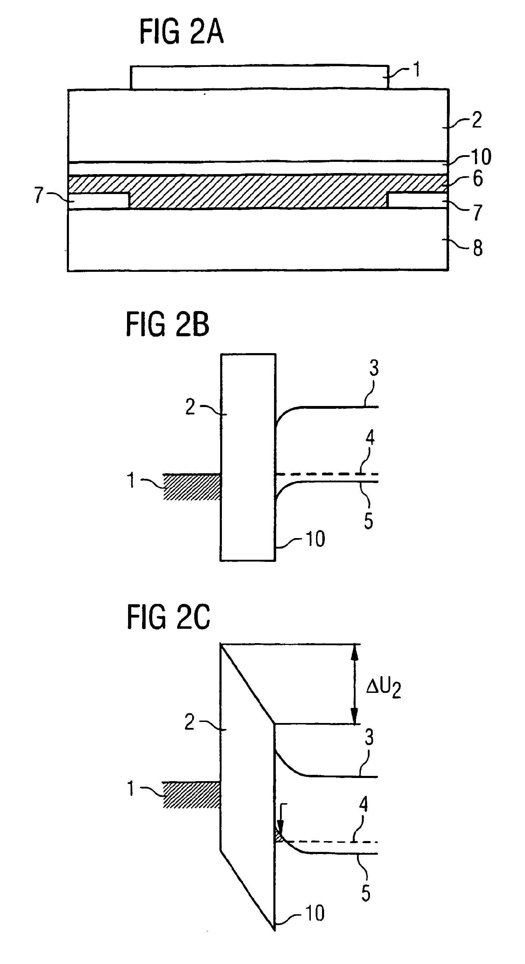

Figur 2a zeigt den Aufbau eines OFETs gemäß einer Ausführungsform der Erfindung. Zwischen der Isolatorschicht 2 und: der halbleitenden Schicht 6 befindet sich die raumladungserzeugende Schicht 10. Haupteigenschaften dieser Schicht sind eine geringe Austrittsarbeit, sowie eine hohe Zahl von Donatoren. Aufgrund dieser Eigenschaften werden die Ladungsträger der angrenzenden Halbleiterschicht an diese Donatoren gebunden. Dadurch entsteht eine Raumladungszone. d.h. ein Bereich, indem sich keine freien Ladungsträger befinden. In der Figur 2b erkennt man diese Raumladungszone durch die nach unten verbogenen LUMO- und HOMO-Niveaus 3 und 4 nahe der Grenzfläche Halbleiter / Isolator. Erhöht man an diesen OFET die Gate-Spannung, so kann bei kleinen Spannungen noch kein Stromkanal erzeugt werden, da zuerst alle Donatoren mit Löchern gefüllt werden müssen. Erst bei einer höheren Spannung ΔU₂, wenn die Donatoren kompensiert sind, kann ein Stromkanal 9 im OFET erzeugt werden (siehe Figur 2c). Die Differenz zischen der Spannung ΔU₁ (in Fig. 1c) und ΔU₂ (in Fig. 2c) entspricht der Verschiebung der Schwellwertspannung.

Inhalt der Erfindung ist die Einführung einer sehr dünnen, nichtleitenden Schicht zwischen halbleitendem Material und Isolator im OFET. Durch die Erfindung wird es erstmals möglich, die Schwellwertspannung eines OFETs zu verschieben und gleichzeitig die Herstellung des OFETs zu vereinfachen, da auf Sauerstoffaussschluß während der Herstellung verzichtet werden kann.

## Patentansprüche

1. OFET, zwischen zwei Elektrodenschichten, einer
Source/DrainElektrodenschicht und einer Gate-Elektrodenschicht zumindest eine aktive Schicht umfassend, wobei zwischen der Gate-Isolatorschicht und der aktiven, p-halbleitenden Schicht eine nichtleitende zwischen 1 und 50 Nanometer dicke Zwischenschicht angeordnet ist, die aus einem
Material mit einer Anzahl an Donatoren ausgebildet ist, die so gewählt ist, dass sich durch die Donatoren eine Raumladungszone in der aktiven Schicht ausbildet und sich die Schwellwertspannung des OFET **dadurch** verschiebt,
**dadurch gekennzeichnet, dass** die Zwischenschicht auf die aktive p-halbleitende Schicht aufgebracht ist und dass der OFET ein Top-Gate OFET ist.

2. OFET nach Anspruch 1, bei dem die Zwischenschicht aus kleinen, polarisierbaren Molekülen mit internem Dipolmoment besteht.

3. OFET nach einem der vorstehenden Ansprüche, dessen halbleitendes Material Polyalkylthiophen ist.

4. OFET nach einem der Ansprüche 1 oder 3, bei dem die Zwischenschicht aus Di-Sulfid-Dipolmolekülen oder aus Silanen, Fullerenen oder Perylenen ist.

5. Verwendung eines OFET nach einem der vorstehenden Ansprüche 1 bis 4 in einem RFID Tag.

## Claims

1. OFET, comprising at least one active layer between two electrode layers, a source/drain electrode layer and a gate electrode layer, wherein a non-conductive interlayer having a thickness of between 1 and 50 nanometres is arranged between the gate insulator layer and the active, p-semiconducting layer, said interlayer being formed from a material having a number of donors chosen such that, as a result of the donors, a space charge zone is formed in the active layer and the threshold voltage of the OFET is shifted as a result, **characterized in that** the interlayer is applied to the active p-semiconducting layer, and **in that** the OFET is a top-gate OFET.

2. OFET according to Claim 1, in which the interlayer is composed of small polarisable molecules having an internal dipole moment.

3. OFET according to either of the preceding claims, the semiconducting material of which is polyalkylthiophene.

4. OFET according to either of Claims 1 and 3, in which the interlayer is composed of disulphide dipole molecules or of silanes, fullerenes or perylenes.

5. Use of an OFET according to any of the preceding Claims 1 to 4 in an RFID tag.

## Revendications

1. Transistor organique à effet de champ entre deux couches d'électrodes, une couche d'électrode source/de canalisation et une couche d'électrodes Gate comportant au moins un couche active, sachant qu'entre la couche isolante Gate et la couche active semi-conductrice p est placée une couche non conductrice et une couche intermédiaire de 50 nanomètres d'épaisseur qui est figurée par un matériau avec un nombre de donateurs choisi de telle sorte qu'à travers les donateurs, se forme une zone de charge d'espace dans la couche active et que la tension de seuil du transistor organique à effet de champ est déphasée,
**Caractérisé en ce que** la couche intermédiaire est appliquée sur la couche active semi-conductrice p et **en ce que** le transistor est un transistor Top-Gate.

2. Transistor organique à effet de champ selon la revendication 1, où la couche intermédiaire est constituée de petites molécules polarisantes avec un moment dipolaire interne.

3. Transistor organique à effet de champ selon l'une des revendications suivantes, dont le matériau semi-conducteur est du polyalkylthiophène.

4. Transistor organique à effet de champ selon l'une des revendications 1 à 3, où la couche intermédiaire est en molécules dipolaires de bisulfure ou en silane, en fullerènes ou en pérylènes.

5. Utilisation d'un transistor organique à effet de champ selon l'une des revendications 1 à 4 dans un jour RFID.
